# EUROPEAN PATENT APPLICATION

(11) **EP 3 576 140 A1**
(43) Date of publication of application: **04.12.2019**
(21) Application number: 18175344.3
(22) Date of filing: 31.05.2018
(51) Int. Cl.: H01L 23/36, H01L 23/367, H01L 23/427, H01L 23/373

(54) **HEATSINK AND METHOD OF MANUFACTURING A HEATSINK**

(71) Applicant: ABB Schweiz AG, 5400 Baden (CH)
(72) Inventor: Silvennoinen, Mika, 00380 Helsinki (FI); Manninen, Jorma, 00380 Helsinki (FI); Pakarinen, Joni, 00380 Helsinki (FI)
(74) Representative: Kolster Oy Ab

(57) **Abstract**

A heatsink and a method of manufacturing a heatsink. The heatsink comprises a base plate and at least one cooling fin, wherein the base plate comprises a surface arranged to receive a heat source in mating connection. The heatsink base plate comprises at least one heatsink insert and a heatsink body block attached together, the at least one heatsink insert having different thermal properties than the heatsink body block, and at least part of a surface of the heatsink insert is adapted to form at least a part of the surface arranged to receive the heat source in mating connection.

## Description

### FIELD OF THE INVENTION

The present invention relates to heatsinks, and particularly to heatsinks for power electronic modules.

### BACKGROUND OF THE INVENTION

Power electronic modules are used in power electronic devices such as inverters or frequency converters. One power electronic module comprises multiple of power electronic switches which are capable of switching high currents and able to withstand high voltages over the components. In many devices, such as inverters and frequency converters, the operation is based in operating power electronic switches with a high frequency to produce a desired voltage or current to a load.

Power electronic modules' heat loss is dissipated mainly via its base plate that has to be in good thermal connection with a cooling device like air cooled heatsink, liquid cold plate or thermosyphon heatsink. The thermal characteristics of the cooling device have to be designed according to both the power electronic module and its usage profile.

A frequency converter or an inverter of a high speed motor drive has increased heat losses because of higher switching frequency. Further high power cyclic applications have higher thermal induced stresses within the power electronic module. Conventional aluminum heatsinks' thermal characteristics are well known and utilized quite well too. However, the increasing heating power density (W/cm2) of power electronic modules requires more efficient cooling solutions. Also, the common aluminum heatsinks' time constants are insufficient (too long) for the high power cyclic applications. Much faster response is needed to avoid excessive junction temperatures and to achieve long service life.

Specific heatsink designs have been developed to both reduce thermal resistance and enhance their power cycle response. These heatsink improvements relate, for example, to special cooling fin designs for enhanced surface area and/or enhanced heat transfer coefficient, combination of different construction materials (Al+Cu), and use of two-phase construction parts like heat-pipes for increased heat spreading within the heatsink. Especially the two-phase heatsinks are proven to work well in many thermally demanding applications.

The common heatsink design problem relates to insufficient cooling fin efficiency. Aluminum is relatively inexpensive material and easy to manufacture but its thermal conductivity (k∼200 W/mK) is often insufficient. Copper fins or base plate inserts (k∼380 W/mK) are commonly considered but this increases the total weight and cost significantly.

### BRIEF DESCRIPTION OF THE INVENTION

An object of the present invention is to provide a heatsink and a method of manufacturing a heatsink so as to alleviate the above disadvantages. The objects of the invention are achieved by a heatsink and a method of manufacturing a heatsink, which are characterized by what is stated in the independent claims. The preferred embodiments of the invention are disclosed in the dependent claims.

The invention is based on the idea of providing a heatsink in which a heatsink insert is attached to a heatsink body block. The surface of the attached insert forms at least a part of the surface of the heatsink to which a heat source to be cooled can be attached. The heatsink body block is typically made of aluminium and the heatsink insert may be of copper or may comprise a vapour chamber.

The heatsink of the invention has good thermal properties as the heat generated by the heat source is effectively spread to the heatsink and further effectively removed from the heatsink. The heat is spread to the cooling mass of the heatsink as the heat source is preferably thermally connected to the surface of the insert. The insert conducts the heat to the heatsink body block, which is preferably of aluminium.

The heatsink of the invention can be tailored to specific needs by modifying the shape and size of the heatsink insert. The heatsink body block to which the insert is connected is modified according to the shape and size of the heatsink insert. The invention provides efficient cooling, cost effective structure and possibility to design the heatsink according to the cooled object. The design of the thermal properties of the heatsink can be based on the type of the heat source which is typically a power electronic module with multiple of power semiconductor switch components. Further, the thermal design of the heatsink may take into account the intended use of the device in which the power electronic module is employed.

### BRIEF DESCRIPTION OF THE DRAWINGS

In the following the invention will be described in greater detail by means of preferred embodiments with reference to the attached drawings, in which
Figure 1 shows a perspective view of a heatsink according to an embodiment of the invention;
Figures 2 and 3 show cross-section views of the embodiment of Figure 1; and
Figures 4, 5, 6, 7, 8 and 9 show different embodiments of the invention.

### DETAILED DESCRIPTION OF THE INVENTION

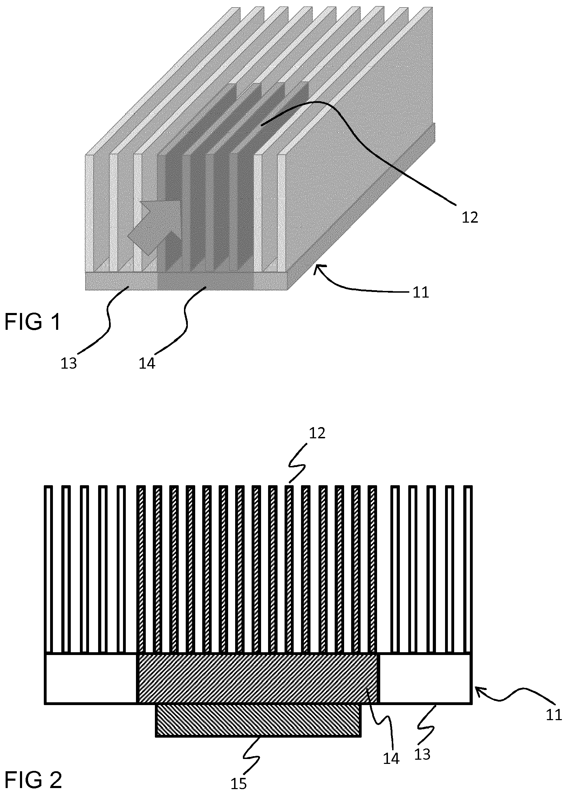

Figure 1 shows a perspective view of a heatsink according to an embodiment of the invention. The heatsink of Figure 1 consists of a base plate 11 and at least one cooling fin 12. The base plate of the heatsink is arranged to receive a heat source in thermal connection such that the heat from the heat source is transferred to the heatsink effectively.

The base plate of the heatsink comprises heatsink body block 13 and at least one heatsink insert 14. In the embodiment, the heatsink insert is made of copper and is attached to the body block 13 preferably by welding, for example by laser welding. As seen in Figure 1, the heatsink insert comprises at least one cooling fin, and in the shown embodiment, the heatsink insert has four cooling fins and also the body block comprises set of cooling fins arranged on the surface that is opposite to the surface that is arranged to receive the heat source. According to another embodiment, the heatsink insert is formed of aluminium and comprises a construction with which the heat transfer or heat spreading is enhanced, thus the thermal properties of the heat sink insert differ from the thermal properties of the body block. The purpose of the heatsink insert is to effectively transfer and spread the heat from the heat source to the mass of the heatsink and to surrounding air. The thermal properties of the heatsink insert differ from the thermal properties of the heatsink body block as the materials are different or the heatsink insert has a heat transfer construction.Further in the invention, at least part of a surface of the heatsink insert forms at least a part of the surface which is arranged to receive the heat source. As shown in Figure 1, the insert 14 is arranged is the body block 13 such that the bottom surfaces to the body block and the insert are at the same level. When the insert is attached to the body block, a uniform heatsink structure is obtained. The heat source is attached to the bottom surface of the heatsink which in the embodiment of Figure 1 is the surface that is on the opposite side of the base plate than the cooling fins. The heat source can be attached to be in contact with only the insert. Alternatively, the heat source can be attached to the heatsink in such a manner that the heat source is in contact with the body block and the insert. Typically, however, the heat source that is to be cooled is in thermal contact with the insert.

In the example of Figure 1, the insert 14 is shown to be situated in one side of the heatsink. In the example, an arrow indicates the direction of cooling air flow. The insert is located nearest to the cooling air inlet i.e. the insert is located in the upstream of cooling air flow. When the cooling air flows as indicated by the arrow, the heat from the insert is transferred to the body block of the heat sink and to the surrounding air through the fins of the heatsink. However, the cooling air flow direction is case dependent and relate, for example, to the electric components temperature limits.

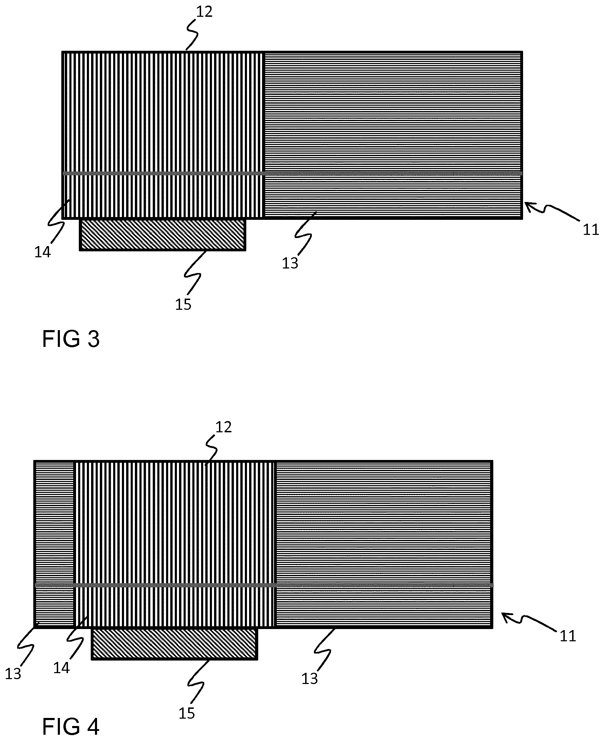

Figures 2 and 3 show cross-sections of an embodiment of the invention together with a heat source that is in contact with the surface of the heatsink. The cross-sections represent similar structure as presented in perspective view of Figure 1. It is shown in Figures 2 and 3 that the heat source is attached to the copper insert. Both the cross-sections are taken through the heat source such that the position of the heat source is shown.

Figure 4 shows a cross-section of another embodiment of the invention in which the insert is situated more centrally in the body block. The cross-section is taken in the direction of the cooling fins and it shows how the insert is situated with respect to the body block of the heatsink. The heatsink of the embodiment has aluminium body blocks attached to the heatsink insert in both ends of the heatsink, when the ends of the heatsink are defined by the direction of the heatsink fins such that the fins extend from one end to the other end. The ends of the heatsink of Figure 4 are of aluminium body block and the sides surrounding the copper insert may be formed of aluminium body block similarly as shown in Figures 1 and 2. The copper insert is preferably dimensioned in such a manner that the surface forming part of the bottom surface of the heatsink is able to receive the heat source. The heatsink of Figure 4 may be manufactured by cutting a properly sized hole or opening to the body block and attaching the heatsink insert, which may be copper insert, with at least one cooling fin to the hole or opening.

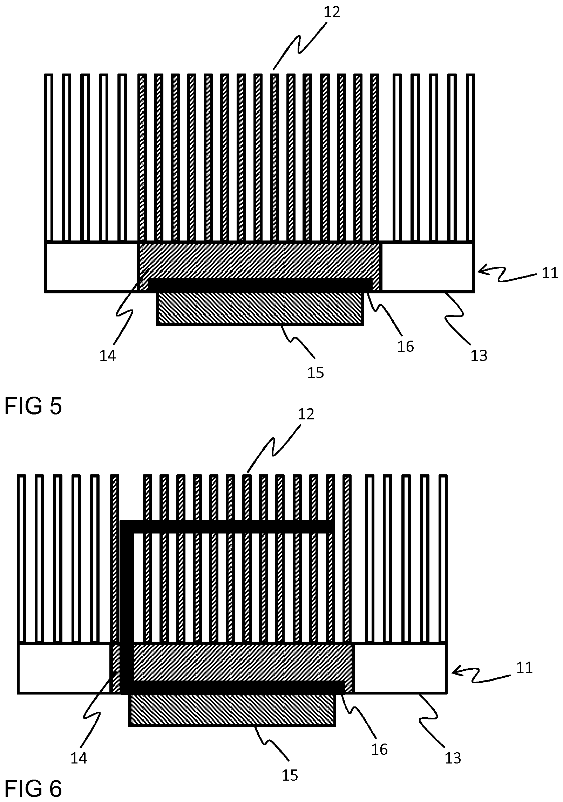

Figure 5 shows a simplified cross-section of another embodiment of the invention. In this embodiment at least one two-phase heat transfer element like heat pipe 16 is attached to the copper insert that forms part of the heatsink of the embodiment. In this embodiment, one or more heat pipes are attached to the heatsink insert to spread the heat inside the insert. As known, heat pipes are effective devices that are used for cooling. Heat pipes are hollow pipes which include a liquid which evaporates due to heat. The vapour travels to a cooler place inside the pipe and condenses back to liquid. With the above continuing process heat is effectively removed from the hottest spots. Inside the insert one or more heat pipes spread the heat such that the insert is heated more uniformly. At the same time this means that the heat is transferred from the hottest places to the cooler places and further from the copper insert to the body block of the heatsink and to the one or more heatsink fins of the insert. Figure 5 shows an example in which only one heat pipe is visible. However, the number, orientation or position of the heat pipes is not limited and their number, orientation and position can be designed based on the use of the heatsink and the device in which the heatsink is situated. Further, according to an embodiment, the heatsink insert may comprise a vapour chamber which is a two-phase heat transfer structure and operates in a similar manner as a heat pipe.

Figure 6 shows another embodiment of the invention. In this embodiment, one or more heat pipes extend outside the baseplate of the insert. More specifically Figure 6 shows how a heat pipe 16 extends outside the baseplate to the one or more cooling fins of the insert. With the embodiment, the heat is effectively removed from the insert with the aid of the heat pipe to the one or more cooling fins. As heat is removed with the heat pipe from the insert, the cooling of the heat source, such as power electronic module, is more efficient. The heat transferred with the heat pipe is led to the cooling fins and to the surrounding air. The one or more heat pipe further spread heat inside the heatsink insert. Although Figure 6 shows a single heat pipe, the structure may include multiple of heat pipes and part of them may be included in the insert and not extending outside the insert as in connection with the example of Figure 5.

The one or more heat pipes of the heatsink insert may be completely inside the insert or partly exposed in the bottom of the insert. When exposed in the bottom, a heat pipe may be in direct contact with the heat source once attached to the heatsink.

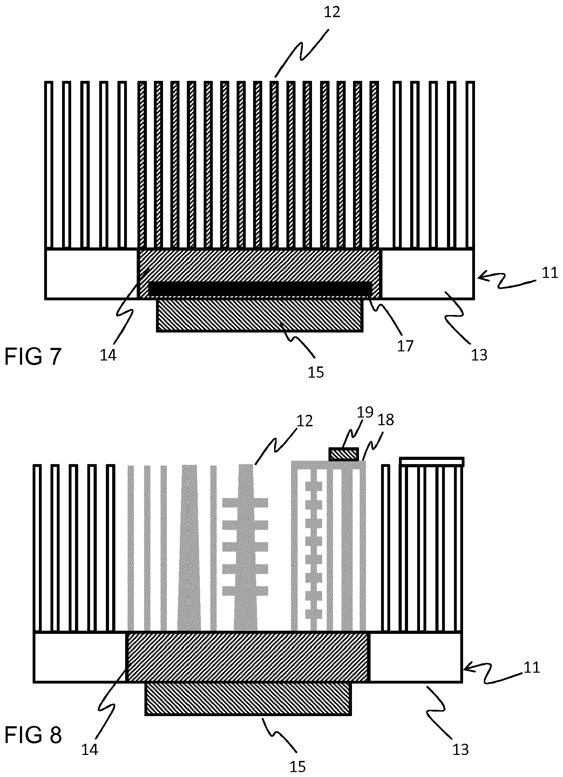

Figure 7 shows another embodiment of the invention in which a carbon heat spreader 17 is embedded into heatsink insert. The carbon heat spreader is preferably manufactured from graphite or graphene and is shaped such that it can be embedded into the insert. Figure 7 shows a cross-section of the heatsink showing that the heat spreader extends in the direction of the width of the heatsink substantially from one side of the insert to the other side of the insert. Similarly, the heat spreader may extend in the direction of the length of the heatsink such that the heat spreader extends from longitudinal one end of the insert to the other end of the insert. However, the heat spreader is completely inside the insert. The heat spreader is enclosed by the insert. The surface area of the heat spreader is preferably larger than the surface area of the heat source. That is, the heat spreader has a bottom which is the surface of the heat spreader closest to the bottom of the surface of the heatsink. The surface area of the bottom surface of the heat spreader is larger than the surface are of the heat source that is to be attached to the heatsink.

The insert is preferably manufactured such that a suitable indent is made to a block of copper, and the heat spreader is inserted to the indent. Once the heat spreader is inserted in the indent, the indent is closed by copper or friction stir welding, for example. The heat spreader of the embodiment operates to spread the heat originating from the heat source. The heat spreader effectively spreads the heat in horizontal direction, i.e. in the direction of the length and width of the heatsink.

Figure 8 shows another embodiment of the invention, in which the one or more of the cooling fins 12 of the heatsink insert are laser welded to the heatsink insert. The laser welded cooling fins may have any profile. As shown in Figure 8, the cooling fins may have different profiles and shapes to enhance the cooling obtained with the heatsink of the invention. Cooling fins are typically vertical structures that extend perpendicularly from the heatsink body. In the embodiment one or more these vertical structures are attached to the heatsink insert using laser welding. As each cooling fin is attached to the insert separately, the cooling fins may be different, and have horizontally extending extension. In the example of Figure 8 a cooling fin comprises a comp-like extending structure. As Figure 8 shows a cross-section of the heat sink, the cooling fin profiles extend in the direction of the length of the heatsink, where the direction of length is defined as the direction of the cooling fins.

Figure 8 also shows an embodiment, in which one or more component mounting plates 18 are attached to the ends of the cooling fins. The cooling fins extend from the baseplate of the heatsink and component mounting plates are attached to the ends of the cooling fins that are at a distance from the baseplate. The component mounting plates are metallic plates to which electronic components 19 can be attached. The attached component mounting plates are adapted to hold components which require cooling and the cooling fins of the heatsink are used to provide cooling to the components attached to the mounting plates.

The heatsink of the invention comprises a heatsink body block and a heatsink insert. The heatsink body block is preferably aluminium and is manufactured in typical manufacturing methods, such as by aluminium casting. The heatsink insert can be specifically manufactured for a certain use, a certain device or for a certain heat source or any combination of these. The heatsink of the invention is manufactured by providing a heatsink body block, providing a heatsink insert, cutting an opening or cut-out to the heatsink body block and attaching the heatsink insert to the opening or cut-out of the heatsink body block. The heatsink insert is preferably a copper insert which is preferably attached to the body block using laser welding.

The heatsink insert that is attached to the body block may comprise any of the modification presented above, for example, the insert may comprise one or more heat pipes or heat spreaders.

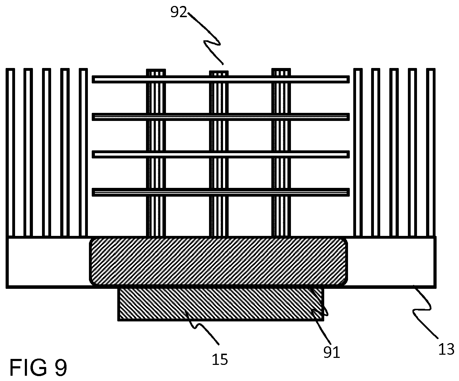

According to an embodiment, the heatsink insert comprises or is a vapour chamber, and preferably comprises at least one cooling fin or condenser pipe. As known, vapour chambers are two-phase heat transfer elements which operate similarly to heat pipes. When a condenser pipe is attached to a vapour chamber, the structure has a uniform volume. That is, the working fluid is able to flow inside the volume of vapour chamber and condenser pipe. The use of the vapour chamber as a structural part of the heatsink insert greatly increases the cooling capacity of the heatsink. Figure 9 shows an example of a heatsink with a heatsink insert comprising a vapour chamber 91. The vapour chamber of the example has three condenser pipes 92 with cooling fins attached to the pipes. The condenser pipes may be situated freely to the surface of the vapour chamber. Similarly, the heatsink insert having the vapour chamber may be situated freely in the heatsink body block, that is, the heatsink insert with the vapour chamber may be situated similarly as the heatsink inserts of the other embodiments.

The heatsink insert of the invention may also be formed of aluminium when efficient heat transfer and/or heat spreading means, such as heat pipes, vapour chambers or graphite material, are applied to the construction of the insert. The use of aluminium brings benefits relating to weight and cost of the structure.

It will be obvious to a person skilled in the art that, as the technology advances, the inventive concept can be implemented in various ways. The invention and its embodiments are not limited to the examples described above but may vary within the scope of the claims.

## Claims

1. A heatsink comprising a base plate and at least one cooling fin, wherein the base plate comprises a surface arranged to receive a heat source in mating connection, wherein
the heatsink base plate comprises at least one heatsink insert and a heatsink body block attached together,
the at least one heatsink insert having different thermal properties than the heatsink body block, and
at least part of a surface of the heatsink insert is adapted to form at least a part of the surface arranged to receive the heat source in mating connection.

2. A heatsink according to claim 1, wherein the heatsink body block is of aluminium.

3. A heatsink according to claim 1 or 2, wherein the heatsink insert is of copper and comprises at least one cooling fin.

4. A heatsink according to claim 1, 2 or 3, wherein the heatsink insert comprises one or more heat pipes embedded at least partly inside the heatsink insert.

5. A heatsink according to claim 4, wherein at least one heat pipe is embedded completely inside the heatsink insert.

6. A heatsink according to claim 4 or 5, wherein at least one heat pipe extends from the heatsink insert outside the heatsink insert and to the at least one cooling fin.

7. A heatsink according to any one of the previous claims 1 to 6, wherein the heatsink insert comprises a carbon heat spreader.

8. A heatsink according to claim 7, wherein the carbon heat spreader is of graphite or graphene and has a bottom surface having an area which is larger than the surface area of the heat source.

9. A heatsink according to any one of the previous claims 1 to 8, wherein the at least one cooling fin is attached to the heatsink insert by laser welding.

10. A heatsink according to any one of the previous claims 1 to 9, wherein the heatsink insert is attached to the heatsink body block by laser welding.

11. A heatsink according to claim 1 or 2, wherein the heatsink insert comprises a vapour chamber.

12. A heatsink according to claim 11, wherein the vapour chamber comprises at least one cooling fin or at least one condenser pipe.

13. A heatsink according to any one of the previous claims 3 to 10 or 12, wherein the heatsink comprises a component mounting plate attached to the at least one cooling fin, the component mounting plate being adapted to hold one or more electrical components.

14. A method of manufacturing a heatsink comprising
providing a heatsink body block,
providing a heatsink insert having different thermal properties than the heatsink body block,
cutting an opening or cut-out to the heatsink body block and
attaching the heatsink insert to the opening or cut-out of the heatsink body block.

15. A method according to claim 14, wherein at least one cooling fin is attached to the heatsink insert by laser welding.

16. A method according to claim 14, wherein attaching of the heatsink insert to the heatsink body block comprises laser welding the heatsink insert to the heatsink body block.
